# EUROPÄISCHE PATENTSCHRIFT

(11) **EP 0 786 017 B1**
(45) Veröffentlichungstag und Bekanntmachung des Hinweises auf die Patenterteilung: **24.03.1999**
(21) Anmeldenummer: 95935429.1
(22) Anmeldetag: 04.10.1995
(51) Int. Cl.: C23C 4/02

(54) **SCHUTZSCHICHT ZUM SCHUTZ EINES BAUTEILS GEGEN KORROSION, OXIDATION UND THERMISCHE ÜBERBEANSPRUCHUNG SOWIE VERFAHREN ZU IHRER HERSTELLUNG**
PROTECTIVE LAYER FOR PROTECTING PARTS AGAINST CORROSION, OXIDATION AND EXCESSIVE THERMAL STRESSES, AS WELL AS PROCESS FOR PRODUCING THE SAME
COUCHE DE PROTECTION DE PIECES CONTRE LA CORROSION, L'OXYDATION ET LES CONTRAINTES THERMIQUES EXCESSIVES, ET SON PROCEDE DE PRODUCTION

(30) Priorität: 14.10.1994 EP 94116247
(43) Veröffentlichungstag der Anmeldung: 30.07.1997
(73) Patentinhaber: SIEMENS AKTIENGESELLSCHAFT, 80333 München (DE)
(72) Erfinder: SCHMITZ, Friedhelm, D-46537 Dinslaken (DE); CZECH, Norbert, D-46286 Dorsten (DE)
(86) Internationale Anmeldenummer: EP9503919
(87) Internationale Veröffentlichungsnummer: WO9612049

(56) Entgegenhaltungen:
- EP-A- 0 207 874
- EP-A- 0 266 299
- EP-A- 0 412 397
- WO-A-89/07159
- CH-C- 660 200

## Beschreibung

Die Erfindung betrifft eine mehrlagige Schutzschicht die zum Schutz gegen Korrosion und Oxidation bei einer hohen Temperatur sowie gegen thermische Überbeanspruchung auf ein Bauteil auf gebracht ist, ein Verfahren zur Beschichtung eines Bauteils mit einer mehrlagigen Schutzschicht sowie ein mit einer mehrlagigen Schutzschicht beschichtetes Bauteil, insbesondere ein Bautei einer Gasturbine.

Aus der EP 0 266 299 A2 geht ein Metallgegenstand, insbesondere eine Gasturbinenschaufel, mit einer Schutzschicht zum Schutz des Metallgegenstandes bei erhöhter Temperatur hervor. Die Schutzschicht umfaßt eine keramische Wärmedämmschicht aus Zirkonoxid mit einem Zusatz von Yttriumoxid und einer die Wärmedämmschicht mit dem Metallgegenstand verbindenden Haftschicht aus einer Legierung, die sich aus folgenden Gewichtsanteilen zusammensetzt: 15 - 40 % Kobalt, 10 - 40 % Chrom, 6 - 15 % Aluminium, 0 - 2 % Hafnium, 0 - 7 % Silizium, 0,01 - 1,0 % Yttrium, Rest Nickel. Die Haftschicht und die Wärmedämmschicht können durch atmosphärisches Plasma-Spritzen auf den Metallgegenstand aufgebracht werden.

Metallische Schutzschichten zur metallische Bauteile, insbesondere für Bauteile einer Gasturbine, die deren Kortosions-beständigkeit und/oder Oxidationsbeständigkeit erhöhen sollen, sind im Stand der Technik bekannt. Für stationäre Gasturbinen mit Werkstofftemperaturen von ca. 950 °C und für Gasturbinen in FLugtriebwerken mit Eintrittstemperaturen von ca. 1100 °C ist eine den thermodynamischen Wirkungsgrad beeinflussende Steigerung der Eintrittstemperatur durch den einsatz speziell entwickelter Legierungen als Grundstoffe für thermisch hochzubelastende Bauteile, wie Leitsctaufeln und Laufschaufeln, erreicht worden. Insbesondere durch den Einsatz einkristalliner Superlegierungen konnten für diese Bauteile Temperaturen von deutlich über 1000 °C in Betracht gezogen werden. Neben thermomechanischen Beanspruchungen ist ein solches Bauteil auch einem chemischen Angriff, beispielsweise durch ein Rauchgas mit einer Temperatur bis über 1300 °C, ausgesetzt. Für eine hinreichende Beständigkeit gegenüber einem solchen Angriff ist das Bauteil üblicherweise mit einer metallischen Schutzschicht überzogen. Die Schutzschicht muß hinreichend gute mechanische Eigenschaften aufweisen. Insbesondere im Hinblick auf die mechanische Wechselwirkung zwischen der Schutzschicht und dem Grundwerkstoff des Bauteiles sollte die Schutzschicht hinreichend duktil sein, um eventuellen Verformungen des Grundwerkstoffs folgen zu können; sie sollte auch möglichst wenig rißanfällig sein, um eine Korrosion und Oxidation des Grundwerkstoffes zu verhindern.

Eine Vielzahl von Schutzschichten ist unter dem Sammelbegriff MCrAlY bekannt, wobei M für mindestens eines der Elemente aus der Gruppe umfassend Eisen, Kobalt und Nickel steht und weitere wesentliche Bestandteile Chrom, Aluminium und Yttrium oder ein diesem äquivalentes Metall aus der Gruppe umfassend Scandium und die Elemente der Seltenen Erden sind.

Eine solche Legierung, die in einem Verfahren zur Verbesserung der Oxidationsbeständigkeit eines mit einer Schutzschicht überzogenen Bauteiles aus einer Superlegierung Anwendung findet, ist in der US-Patentschrift 4,451,299 beschrieben. Die Schutzschicht enthält 15 - 45 % Chrom, 7 - 20 % Aluminium sowie 0,1 - 5 % Yttrium (Angabe jeweils in Gewichtsprozent). Das Yttrium kann durch Lanthan und Cer ersetzt werden. Darüber hinaus enthält die Schutzschicht fakultativ eine Beimischung weiterer Elemente aus der Gruppe enthaltend Platin, Rhenium, Silizium, Tantal und Magnesium bis zu 10 %. Inwieweit eine Zugabe eines dieser fakultativen Elemente zur Verbesserung der Oxidationsbeständigkeit der Superlegierung beiträgt, ist der US-Patentschrift nicht zu entnehmen. Auch die wenig spezifizierten weiten Bereiche der möglichen Beimischung geben keine Qualifizierung der Schutzschicht für besondere Bedingungen an, beispielsweise bei einer stationären Gasturbine mit hoher Eintrittstemperatur, wenn diese außer im Vollastbetrieb auch im Teillastbetrieb über längere Zeiträume betrieben wird.

Eine Schutzschicht, die die Korrosions- und Oxidationseigenschaften in einem Oberflächen-Temperaturbereich von 600 °C bis 1150 °C verbessern soll, ist in der EP 0 412 397 Al beschrieben. Die Schutzschicht weist neben 22 - 50 % Chrom, 0-15 % Aluminium, 0,3 - 2 % Yttrium oder eines anderen Elementes aus der Gruppe der Seltenen Erden einen Anteil von 1 bis 20 % Rhenium auf. Die Wirkung des Rheniums im Hinblick auf eine Verbesserung korrosiver oder oxidierender Einflüsse ähnelt den positiven Wirkungen von Platin. Aufgrund der guten thermischen Leitfähigkeit der metallischen Schutzschicht wird ein mit der Schutzschicht überzogenes Bauteil nahezu derselben thermischen Belastung ausgesetzt, wie die Schutzschicht selbst.

In der WO 89/07159 A1 ist eine zweilagige metallische Schutzschicht aus zwei unterschiedlichen Legierungen beschrieben. Die außen liegende dieser Legierungen fällt unter den Sammelbegriff MCrAlY und enthält (in Gew.-% angegeben) 15 bis 40 % Chrom, 3 bis 15 % Aluminium sowie 0,2 bis 3 % mindestens eines Elements aus der Gruppe umfassend Yttrium, Tantal, Hafnium, Scandium, Zirkonium, Niob, Rhenium und Silizium. Diese Legierung ist ihrerseits vorzugsweise, insbesondere auf einem von innen gekühlten Bauteil, zum Schutz gegen besonders hohe Temperaturen mit einer Thermobarriereschicht umgeben. Die Thermobarriereschicht kann Zirkoniumoxid mit einem Zusatz von Yttriumoxid sein. Um ein mögliches Abplatzen der Thermobarriereschicht von der Legierung zu verhindern, ist eine Oxidation der Legierung vor Aufbringen der Thermobarriereschicht vorgesehen.

In der EP 0 532 150 A1 ist ein mit einer Schutzschicht überzogenes Bauteil aus einer Superlegierung, beispielsweise eine Turbinenschaufel, angegeben. Die Schutzschicht enthält neben Chrom und Aluminium als notwendiges Element Tantal zu mindestens 2 % (Angabe in Gew.-%). Fakultativ beinhaltet die Schutzschicht Yttrium bis zu 1 % und Rhenium bis zu 4 %. Für eine Schutzschicht aus einer solchen Legierung wird in der EP 0 532 150 A1 ein Überzug aus einer keramischen Thermobarriere für möglich gehalten, ohne auf die bei Temperaturänderungen kritische Wechselwirkung zwischen Legierung und Thermobarriere einzugehen.

Die US-Patente 4,055,705, 4,321,310 und 4,321,311 betreffen Schutzschichten für Gasturbinenkomponenten aus Superlegierungen auf Nickel- oder Kobaltbasis. Nach diesen Patenten umfaßt eine Schutzschicht eine keramische Wärmedämmschicht, welche vorzugsweise eine säulenkristalline oder stengelkristalline Struktur hat und auf einer Haftschicht aufliegt, die ihrerseits auf dem Grundwerkstoff der Gasturbinenkomponente aufliegt und die Wärmedämmschicht an den Grundwerkstoff bindet. Die Haftschicht besteht aus einer Legierung des Typs MCrAlY. Wesentlich ist, daß die Haftschicht zwischen sich und der Wärmedämmschicht eine dünne Lage aus Aluminiumoxid entwikkelt, an welcher die Wärmedämmschicht verankert wird.

Das US-Patent 5,087,477 stellt ein Verfahren zum Aufbringen einer keramischen Wärmedämmschicht auf eine Gasturbinenkomponente vor. Dieses Verfahren umfaßt einen Prozeß der physikalischen Dampfabscheidung (physical vapour deposition, PVD), wobei Verbindungen, die die Wärmedämmschicht bilden sollen, mit einem Elektronenstrahl verdampft werden und in der Umgebung der Komponente eine Atmosphäre mit einem bestimmten und sorgfältig kontrollierten Gehalt an Sauerstoff hergestellt wird.

Aufgabe der vorliegenden Erfindung ist es, eine Schutzschicht umfassend eine keramische Wärmedämmschicht und eine Haftschicht des Typs MCrAlY anzugeben, die eine gute Beständigkeit gegen Korrosion und Oxidation bei einer hohen Temperatur aufweist, die einer hohen thermomechanischen Wechsel- und Dauerbeanspruchung angepaßt ist und die eine geringe Wärmeübertragung gewährleistet. Weiterhin liegt der Erfindung die Aufgabe zugrunde, ein Verfahren zur Beschichtung eines Bauteiles mit der Schutzschicht anzugeben.

Die auf die Schutzschicht gerichtete Aufgabe wird erfindungsgemaß gelöst durch eine Schutzschicht zum Schutz eines Bauteils gegen Korrosion und Oxidation bei einer hohen Temperatur sowie gegen thermische Überbeanspruchung, wobei die Schutzschicht auf das Bauteil aufgebracht ist und eine Wärmedämmschicht aus einem keramischen Material und eine die Wärmedämmschicht mit dem Bauteil verbindende Haftschicht aus einer Legierung folgender Zusammensetzung aufweist (Angaben in Gew.-%) : 5 - 20 % Rhenium, 15-35 % Chrom, 7 - 18 % Aluminium, 0,3 - 2 % Yttrium und/oder zumindest ein äquivalentes Metall aus der Gruppe umfassend Scandium und die Elemente der Seltenen Erden, 0 - 3 % Silizium, 0 - 5 % Hafnium, 0 - 5 % Tantal, 0 bis 2 % Zirkon, 0 - 12 % Wolfram, 0 - 10 % Mangan, 0 - 4 % Niob und einem Rest aus Kobalt und/oder Nickel sowie herstellungsbedingten Verunreinigungen.

Im Hinblick auf die vorteilhaften thermo-mechanischen Eigenschaften der Zusammensetzung der Legierung sind die zusätzlicher Elemente (Si, Hf, Ta, Zr, W, Mn) nicht unbedingt erforderlich, wobei die Haftschicht vorzugsweise frei von Wolfram, Mangan und Niob ist. Der Anteil an Tantal liegt vorzugsweise unter 2 %, insbesondere unter 1 %.

Durch eine mehrlagige Schutzschicht mit zumindest einer Wärmedämmschicht und zumindest einer Haftschicht, durch die die Wärmedärmmschicht mit einem Bauteil verbunden ist, wird sowohl der Schutz des Bauteils gegen Korrosion und Oxidation als auch eine Wärmedämmung gegenüber einer an der Außenseite der Wärmedämmschicht vorhandenen hohen Temperatur erreicht. Gegenüber einer rein metallischen Schutzschicht ist dadurch ein dauerhafter Einsatz eines Bauteiles, beispielsweise in einer Gasturbine, bei beträchtlich höherer Umgebungstemperatur ermöglicht. Dabei kann sich über der Schutzschicht eine Temperaturdifferenz bis zu 100 °C, eventuell sogar mehr, einstellen. Bei einer Gasturbine kann daher die Eintrittstemperatur des Rauchgases erhöht werden. Somit wird der thermodynamische Wirkungsgrad der Gasturbine verbessert.

Durch die Zugabe des Elementes Rhenium zu der Legierung der Art MCrAlY wird sowohl die Oxidations- und Korrosionsbeständigkeit der Legierung als auch deren Thermoermüdungseigenschaft nachhaltig verbessert. Aufgrund der geringen Oxidationsgeschwindigkeit einer solchen Legierung findet eine Oxidation der Haftschicht, beispielsweise aufgrund einer Sauerstoffdiffusion durch die keramische Wärmedämmschicht hindurch, nur äußerst langsam statt. Zudem zeigte sich überraschenderweise, daß die Thermoermüdungseigenschaften der Rhenium-haltigen Legierung im Wechselspiel mit der Wärmedämmschicht deutlich verbessert sind. Die Gefahr eines Abplatzens der Wärmedämmschicht ist dadurch signifikant verringert. Ein Versagen der Schutzschicht, in diesem Fall ein Ablösen der Wärmedämmschicht von der Haftschicht, kann demnach erst nach sehr langen Einsatzzeiten auftreten. Die Lebensdauer eines Bauteiles, insbesondere innerhalb einer Gasturbine, wird hierdurch nachhaltig verlängert. Auch das Auftreten von Rissen in der Haftschicht durch Thermoermüdung, d.h. durch einen zyklischen Dehnungswechsel aufgrund von Temperaturänderungen, wird durch die Legierung ebenfalls deutlich verringert. Dies trifft selbst für diejenigen Randbereiche der Schutzschicht zu, die rißgefährdet sind, insbesondere in der Nähe von Kühlluftbohrungen in Gasturbinenschaufeln.

Je nach Anforderung kann die Schutzschicht aus mehreren Schichten aufgebaut sein. Dies trifft sowohl für die Wärmedämmschicht als auch für die Haftschicht zu; beide können jeweils aus mehreren Schichten bestehen.

Die vorteilhaften geringen Oxidationseigenschaften der Rhenium enthaltenen Legierung zeigen sich beispielsweise bei isothermen Temperaturbelastungen von 950 - 1000 °C über eine Zeitdauer von bis zu 5000 Stunden.

Bei einer Legierung, welche 7 bis 15 % Aluminium, 15 bis 30 % Chrom und 5 bis 10 % Rhenium enthält, treten die günstigen Eigenschaften hinsichtlich Oxidations- und Korrosionsbeständigkeit sowie Thermoermündung besonders hervor. Der Chromanteil liegt vorzugsweise zwischen 23 und 28 %.

Die Legierung mit einem Rhenium-Anteil von über 5 % zeigt eine signifikant geringere Oxidationsgeschwindigkeit gegenüber Legierungen der Art MCrAlY ohne Rhenium-Zusatz, was zu einer Ausbildung einer dünneren Oxidschicht führt, wie es beispielsweise Experimente unter zyklischer Oxidationsbelastung bei Temperaturänderungen zwischen 300 °C und 1000 °C gezeigt haben. Eine dünne Oxidschicht an der Grenzfläche zwischen der Haftschicht und der keramischen Wärmedämmschicht führt zu einer Verringerung von Zugspannungen innerhalb der keramischen Wärmedämmschicht, wodurch ein Aufreißen und Abplatzen der Wärmedämmschicht nachhaltig verzögert wird.

Die auf eine Schutzschicht gerichtete Aufgabe wird erfindungsgemaß auch gelöst durch eine Schutzschicht zum Schutz eines Bauteils gegen Korrosion und Oxidation bei einer hohen Temperatur und gegen thermische Überbeanspruchung, welche eine Wärmedämmschicht aus einem keramischen Material und eine Haftschicht aus einer Rhenium enthaltenen Legierung aufweist, wobei die Legierung der unter den Sammelbegriff MCrAlY fallenden Gruppe von Legierungen angehört, worin M für Kobalt und/oder Nickel und Y für Yttrium und/oder zumindest ein äquivalentes Metall aus der Gruppe umfassend Scandium und Elemente der Seltenen Erden steht, und mindestens 4 % Rhenium enthält.

Vorzugsweise enthält die Wärmedämmschicht Zirkonoxid (ZrO₂), welches aufgrund seines relativ hohen und damit metallähnlichen Ausdehnungskoeffizienten besonders für einen thermoisolierenden Überzug der Haftschicht geeignet ist. Zur Vermeidung einer gegebenenfalls störenden Phasenumwandlung des Zirkonoxids wird dieses vorzugsweise durch Zugabe von 5-20 %, insbesondere 6 - 8 %, Yttriumoxid (Y₂O₃) stabilisiert.

Erfindungsgemaß ist ein Bauteil, insbesondere ein Bauteil einer Gasturbine, zum Schutz gegen Korrosion und Oxidation bei einer hohen Temperatur mit einer Schutzschicht überzogen, welche mehrschichtig aufgebaut ist und zumindest aus einer Wärmedämmschicht aus einem keramischen Material und einer Haftschicht aus einer Rhenium enthaltenden Legierung der Art MCrAlY besteht. Die Haftschicht ist fest mit dem Grundwerkstoff des Bauteils verbunden und hat zu diesem Grundwerkstoff eine hohe physikalische Kompatibilität sowie eine geringe Diffusionsneigung. Die Wärmedämmschicht wiederum ist auf die Haftschicht aufgebracht und weist vorzugsweise einen der Haftschicht angepaßten thermischen Ausdehnungskoeffizienten auf. Durch die Wärmedämmschicht ist das Bauteil zumindest teilweise thermisch gegenüber der Umgebungsatmosphäre isoliert. Vor allem bei einem Bauteil in einer Gasturbine, die mit einem Rauchgas beaufschlagt wird, welches eine Temperatur oberhalb von 950 °C aufweist, wird dadurch die thermische Belastung auf das Bauteil deutlich verringert. Die Schutzschicht ist besonders qualifiziert zum Schutz eines Bauteiles einer Gasturbine, insbesondere einer Leitschaufel, einer Lauf schaufel, eines Hitzeschildes oder einer anderen Komponente, die mit heißem Gas beaufschlagt wird.

Besonders bei einer Schaufel einer Gasturbine kann die Wärmedämmschicht eine Dicke von 50 µm bis 300 µm haben. Bei einem Hitzeschild einer Gasturbine oder einer anderen feststehenden Komponente beträgt die Dicke der Wärmedämmschicht vorzugsweise 200 µm bis 3000 µm.

Die Dicke der Haftschicht beträgt vorzugsweise 50 µm bis 300 µm.

Die auf ein Verfahren zur Beschichtung eines Bauteils mit einer Schutzschicht gerichtete Aufgabe wird erfindungsgemäß dadurch gelöst, daß die Haftschicht durch thermisches Spritzen, insbesondere Vakuum-Plasma-Spritzen (VPS), oder physikalische Dampfabscheidung (PVD) auf das Bauelement aufgetragen und danach die Wärmedämmschicht mittels Atmosphärischem Plasmaspritzen (APS) oder physikalischer Dampfabscheidung auf die Haftschicht aufgebracht wird. Als Verfahren für die physikalische Dampfabscheidung kommen beispielsweise Aufdampfen, Kathodenzerstäuben und Ionenplattieren in Frage. Je nach Größe und Einsatzgebiet des Bauteils können auch andere Beschichtungsverfahren zur Herstellung sowohl der Haftschicht als auch der Wärmedämmschicht verwendet werden.

Die Erfindung zeichnet sich durch eine mehrlagige Schutzschicht zum Schutz eines Bauteils gegen Korrosion und Oxidation bei einer hohen Temperatur und gegen thermische Überbeanspruchung aus. Die Schutzschicht weist zumindest eine Wärmedämmschicht aus einem keramischen Material und eine Haftschicht aus einer Rhenium enthaltenden Metall-Legierung auf. Die Metall-Legierung gehört den unter den Sammelbegriff MCrAlY fallenden Legierungen an, wobei M für Kobalt und/oder Nickel und Y für Yttrium und/oder zumindest ein äquivalentes Metall aus der Gruppe umfassend Scandium und die Elemente der Seltenen Erden steht. Die Wärmedämmschicht enthält vorzugsweise mit Yttriumoxid stabilisiertes Zirkonoxid. Durch die günstigen Eigenschaften der Haftschicht, wie beispielsweise geringe Oxidationsgeschwindigkeit, hohe Beständigkeit gegen Schwefelverbindungen und hohe mechanische Stabilität bei hohen Temperaturen, wird in Verbindung mit der geringen thermischen Leitfähigkeit der Wärmedämmschicht ein wirksamer und beständiger Schutz des Bauteiles gegenüber Korrosion und Oxidation gewährleistet. Durch hervorragende Thermoermüdungseigenschaften der Haftschicht, insbesondere bei einem Rhenium-Anteil von über 4 %, ist zudem eine wirksame und dauerhafte Verbindung zwischen der keramischen Wärmedämmschicht und der metallischen Haftschicht hergestellt. Die Schutzschicht eignet sich besonders zur Beschichtung eines Bauteiles einer Gasturbine, welches einem heißen Rauchgas ausgesetzt ist. Die Temperaturen an der Oberfläche der Schutzschicht können 950 °C bis zu über 1300 °C betragen. Zur Beschichtung des Bauteiles mit der Schutzschicht wird die Haftschicht bevorzugt mittels Vakuum-Plasma-Spritzens oder physikalischer Dampfabscheidung auf das Bauteil aufgebracht. Auf die Haftschicht wird dann die Wärmedämmschicht mittels Atmosphärischen Plasmaspritzens oder physikalischer Dampfabscheidung aufgetragen.

Ein Ausführungsbeispiele der Erfindung wird nachfolgend erläutert.

Eine Gasturbinenschaufel, hohl zur Durchleitung eines Kühlgases, wird aus dem Werkstoff IN792 gegossen. Dieser Werkstoff setzt sich aus folgenden Gewichtsanteilen zusammen: 0,08 % Kohlenstoff, 12,5 % Chrom, 9,0 % Kobalt, 1,9 % Molybdän, 4,1 % Wolfram, 4,1 % Tantal, 3,4 % Aluminium, 3,8 % Titan, 0,015 % Bor, 0,02 % Zirkonium, Rest Nickel sowie herstellungsbedingte Verunreinigungen in üblichen Anteilen. Diese Gasturbinenschaufel wird gegen Korrosion, Oxidation und übermäßige thermische Beanspruchung wie folgt geschützt:

Zunächst wird eine metallische Haftschicht durch Vakuum-Plasma-Spritzen aufgebracht unter Verwendung eines Pulvers einer Legierung, die sich aus folgenden Gewichtsanteilen zusammensetzt: 25 bis 29 % Kobalt, 21 bis 22 % Chrom, 7 bis 8 % Aluminium, 0,5 bis 0,7 Yttrium, 0,3 bis 0,7 % Silizium, 9,5 bis 10,5 % Rhenium, Rest Nickel sowie herstellungsbedingte Verunreinigungen in üblichen Anteilen. Bei der Aufbringung der Schicht ist durch passende Wahl der Körnung des Pulvers sowie der Betriebsparameter des Spritzverfahrens eine Rauhheit von maximal R_{z} = 30 µm einzustellen. Die Dicke der Haftschicht kann wiederum zwischen 50 µm und 300 µm liegen. Anschließend erfolgt eine Wärmebehandlung der beschichteten Gasturbinenschaufeln für zwei Stunden bei 1120 °C und unter Vakuum. Nach dieser Wärmebehandlung, die wie im ersten Ausführungsbeispiel zur Anbindung der Haftschicht an den Grundwerkstoff der Gasturbinenschaufel durch Interdiffusion dient, wird durch Gleitschleifen, vor dem gegebenenfalls mit Glasperlen oder Sand gestrahlt werden kann, eine Glättung der Haftschicht auf eine Rauhheit von maximal Rₐ = 2 µm vorgenommen.

Auf die so vorbereitete beschichtete Gasturbinenschaufel wird mittels Elektronenstrahlverdampfung und physikalischer Dampfabscheidung (EB-PVD) eine keramische Wärmedämmschicht aufgedampft. Die Zusammensetzung der Wärmedämmschicht entspricht der Zusammensetzung der Wärmedämmschicht im ersten Ausführungsbeispiel; sie wird aufgetragen bis zu einer Dicke zwischen 125 und 175 µm. Der Prozeß der Dampfabscheidung ist so zu führen, daß die Wärmedämmschicht in Form kolumnarer, d.h. stengel- oder stabförmiger, Kristallite aufwächst. Es ist nicht unbedingt erforderlich, Kühlluftbohrungen oder -schlitze während der Aufbringung der Wärmedämmschicht abzudecken; ebenso ist im Regelfall eine Glättung der Wärmedämmschicht nicht nötig. Abschließend wird die fertig beschichtete Gasturbinenschaufel einer erneuten Wärmebehandlung unterzogen; diese Wärmebehandlung erfolgt zunächst für zwei Stunden bei 1120 °C unter Vakuum und anschließend mehrere Stunden lang bei 845 °C unter Luft.

## Patentansprüche

1. Schutzschicht, die auf ein Bauteil aufgebracht ist und zum Schutz des Bauteils gegen Korrosion und Oxidation bei einer hohen Temperatur sowie gegen thermische Überbeanspruchung eine Wärmedämmschicht aus einem keramischen Material und eine die Wärmedämmschicht mit dem Bauteil verbindende Haftschicht aus einer Legierung folgender Zusammensetzung (Angaben in Gewichtsprozent) aufweist :
| | |
|---|---|
| 5 bis 20 % | Rhenium, |
| 15 bis 35 % | Chrom, |
| 7 bis 18 % | Aluminum, |
| 0,3 bis 2 % | Yttrium und/oder zumindest ein äquivalentes Metall aus der Gruppe umfassend Scandium und die Elemente der Seltenen Erden, |
| 0 bis 3 % | Silizium, |
| 0 bis 5 % | Hafnium, |
| 0 bis 5 % | Tantal, |
| 0 bis 2 % | Zirkon, |
| 0 bis 12 % | Wolfram, |
| 0 bis 10 % | Mangan |
| 0 bis 4 % | Niob und |
einen Rest aus Kobalt und/oder Nickel sowie herstellungsbedingte Verunreinigungen.

2. Schutzschicht nach Anspruch 1, enthaltend
| | |
|---|---|
| 7 bis 15 % | Aluminium, |
| 15 bis 30 % | Chrom und |
| 5 bis 11 % | Rhenium. |

3. Schutzschicht, die auf ein Bauteil aufgebracht ist und zum Schutz des Bauteils gegen Korrosion und Oxidation bei einer hohen Temperatur sowie gegen thermische Überbeanspruchung eine Wärmedämmschicht aus einem keramischen Material und eine Haftschicht aus einer Metall-Legierung der Zusammensetzung MCrAlY, worin M für Kobalt und/oder Nickel und Y für Yttrium und/oder zumindest ein äquivalentes Metall aus der Gruppe umfassend Scandium und die Elemente der Seltenen Erden steht und einen Anteil von mindestens 4 % Rhenium (Angabe in Gewichtsprozent) aufweist.

4. Schutzschicht nach einem der vorhergehenden Ansprüche, bei der die Wärmedämmschicht Zirkonoxid (ZrO₂) enthält.

5. Schutzschicht nach Anspruch 4, bei der das Zirkonoxid mit 5 bis 20 %, insbesondere 6 bis 8 %, Yttriumoxid (Y₂O₃) stabilisiert ist.

6. Schutzschicht nach einem der vorhergehenden Ansprüche auf einem Bauteil einer Gasturbine, insbesondere einer Laufschaufel, einer Leitschaufel oder einem Hitzeschild.

7. Schutzschicht nach einem der vorhergehenden Ansprüche, bei der die Dicke der Wärmedämmschicht 50 µm bis 300 µm beträgt.

8. Schutzschicht nach einem der Ansprüche 1 bis 6, bei der die Dicke der Wärmedämmschicht 200 µm bis 3000 µm beträgt.

9. Schutzschicht nach einem der vorhergehenden Ansprüche, bei der die Dicke der Haftschicht 50 µm bis 300 µm beträgt.

10. Verfahren zur Beschichtung eines Bauteils mit einer Schutzschicht nach einem der Ansprüche 1 bis 9, bei dem die Haftschicht mittels thermischem Spritzen oder physikalischer Dampfabscheidung (PVD) und die Närmedämmschicht mittels Atmosphärischem Plasma-Spritzen (APS) oder physikalischer Dampfabscheidung (PVD) auf die Haftschicht aufgetragen wird.

## Claims

1. Protective coat which is applied to a component and, for protecting the component from corrosion and oxidation at a high temperature and from excessive thermal stress, has a heat insulation layer of a ceramic material and an adhesion-promoting layer which binds the heat insulation layer to the component and comprises an alloy of the following composition (data in per cent by weight) :
| | |
|---|---|
| 5 to 20% | of rhenium, |
| 15 to 35% | of chromium, |
| 7 to 18% | of aluminium, |
| 0.3 to 2% | of yttrium and/or at least one equivalent metal from the group comprising scandium and the rare earth elements, |
| 0 to 3% | of silicon, |
| 0 to 5% | of hafnium, |
| 0 to 5% | of tantalum, |
| 0 to 2% | of zirconium, |
| 0 to 12% | of tungsten, |
| 0 to 10% | of manganese and |
| 0 to 4% | of niobium, |
the remainder comprising cobalt and/or nickel and impurities associated with the preparation.

2. Protective coat according to Claim 1, containing
| | |
|---|---|
| 7 to 15% | of aluminium, |
| 15 to 30% | of chromium and |
| 5 to 11% | of rhenium. |

3. Protective coat which is applied to a component and, for protecting the component from corrosion and oxidation at a high temperature and from excessive thermal stress, has a heat insulation layer of a ceramic material and an adhesion-promoting layer comprising a metal alloy of the composition MCrAlY, where M represents cobalt and/or nickel and Y represents yttrium and/or at least one equivalent metal from the group comprising scandium and the rare earth elements, and contains at least 4% of rhenium (stated in per cent by weight).

4. Protective coat according to one of the preceding claims, in which the heat insulation layer contains zirconium oxide (ZrO₂).

5. Protective coat according to Claim 4, in which the zirconium oxide is stabilized with 5 to 20%, in particular 6 to 8%, of yttrium oxide (Y₂O₃).

6. Protective coat according to one of the preceding claims on a component of a gas turbine, in particular a rotor blade, a guide vane or a heat shield.

7. Protective coat according to one of the preceding claims, in which the thickness of the heat insulation layer is 50 µm to 300 µm.

8. Protective layer according to one of Claims 1 to 6, in which the thickness of the heat insulation layer is 200 µm to 3000 µm.

9. Protective layer according to one of the preceding claims, in which the thickness of the adhesion-promoting layer is 50 µm to 300 µm.

10. Process for coating a component with a protective coat according to one of Claims 1 to 9, in which the adhesion-promoting layer is applied by means of thermal spraying or physical vapour deposition (PVD) and the heat insulation layer is applied to the adhesion-promoting layer by means of atmospheric plasma spraying (APS) or physical vapour deposition (PVD).

## Revendications

1. Couche de protection, appliquée sur une pièce et qui, pour protéger la pièce de la corrosion et de l'oxydation à haute température et d'une surcharge thermique, comporte une couche calorifuge en un matériau céramique et une couche d'accrochage qui relie la couche calorifuge à la pièce, en un alliage ayant la composition suivante (indications en % en poids) :
de 5 à 20 % de rhénium,
de 15 à 35 % de chrome,
de 7 à 18 % d'aluminium,
de 0,3 à 2 % d'yttrium et/ou d'au moins un métal équivalent choisi dans le groupe comprenant le scandium et les éléments des terres rares.
de 0 à 3 % de silicium,
de 0 à 5 % de hafnium,
de 0 à 5 % de tantale,
de 0 à 2 % de zirconium,
de 0 à 12 % de tungstène,
de 0 à 10 % de manganèse,
de 0 à 4 % de niobium, et
le reste étant constitué de cobalt et/ou de nickel ainsi que des impuretés dues à la fabrication.

2. Couche de protection selon la revendication 1, qui contient :
de 7 à 15 % d'aluminium,
de 15 à 30 % de chrome, et
de 5 à 11 % de rhénium.

3. Couche de protection, appliquée sur une pièce et qui, pour protéger la pièce de la corrosion et de l'oxydation à haute température et d'une surcharge thermique, comporte une couche calorifuge en un matériau céramique et une couche d'accrochage en un alliage métallique ayant la composition MCrAlY, où M est le cobalt et/ou le nickel, et Y est l'yttrium et/ou au moins un métal équivalent choisi dans le groupe comprenant le scandium et les éléments des terres rares, ainsi qu'une proportion d'au moins 4 % de rhénium (indication en % en poids).

4. Couche de protection selon l'une des revendications précédentes, dans laquelle la couche calorifuge contient de l'oxyde de zirconium (ZrO₂).

5. Couche de protection selon la revendication 4, dans laquelle l'oxyde de zirconium est stabilité avec une quantité de 5 à 20 et en particulier de 6 à 8 % d'oxyde d'yttrium (Y₂O₃).

6. Couche de protection selon l'une des revendications précédentes. appliquée sur une pièce d'une turbine à gaz, en particulier d'une aube directrice, d'une aube mobile ou d'un bouclier thermique.

7. Couche de protection selon l'une des revendications précédentes, dans laquelle l'épaisseur de la couche calorifuge est de 50 à 300 µm.

8. Couche de protection selon l'une des revendications 1 à 6, dans laquelle l'épaisseur de la couche calorifuge est de 200 à 3000 µm.

9. Couche de protection selon l'une des revendications précédentes, dans laquelle l'épaisseur de la couche d'accrochage est de 50 à 300 µm.

10. Procédé pour appliquer sur une pièce une couche de protection selon l'une des revendications 1 à 9, dans lequel la couche d'accrochage est appliquée par projection thermique ou déposition physique en phase vapeur (PVD) et la couche calorifuge est appliquée sur la couche d'accrochage par projection par plasma à la pression atmosphérique (APS) ou par déposition physique en phase vapeur (PVD).
